# EUROPEAN PATENT SPECIFICATION

(11) **EP 2 399 167 B1**
(45) Date of publication and mention of the grant of the patent: **21.10.2015**
(21) Application number: 10711602.2
(22) Date of filing: 16.02.2010
(51) Int. Cl.: G03F 7/00, G03F 7/027, G03F 7/004, B82Y 10/00, C08F 222/10, B82Y 40/00

(54) **NANOLITHOGRAPHY PROCESS**
NANOLITHOGRAFIEVERFAHREN
PROCÉDÉ DE NANOLITHOGRAPHIE

(30) Priority: 19.02.2009 EP 09153205
(43) Date of publication of application: 28.12.2011
(73) Proprietor: Solvay Specialty Polymers Italy S.p.A., 20021 Bollate (MI) (IT)
(72) Inventor: KOO, Namil, 52074 Aachen (DE); PLACHETKA, Ulrich, 41239 Mönchengladbach (DE); MOORMANN, Christian, 52074 Aachen (DE)
(74) Representative: Benvenuti, Federica
(86) International application number: PCT/EP2010/051880
(87) International publication number: WO 2010/094661

(56) References cited:
- EP-A- 1 873 174
- WO-A-2007/127984
- WO-A-2007/133235
- WO-A-2008/015842
- WO-A2-2005/101466
- US-A1- 2003 235 787
- US-A1- 2008 000 373

## Description

### Technical Field

This invention pertains to an improved process for imprinttechnology, suitable for the manufacture of nanopatterned parts.

### Background Art

The field of nanotechnology and microelectronics are closely related, as integrated circuit features are now continuously pushed to the 100 nm regime and beyond. Thus, in order to keep ahead of the ever shrinking feature size, research on manufacturing and metrology methods endeavours to truly enable nanotechnology industries to come to fruition.

Imprint lithography has been recognized as having the potential to offer viable, cost-effective alternatives to optical lithography for manufacturing integrated circuits, optical components, and other devices for sub-100 nm features. In particular, UV-nanoimprint technology using flexible moulds (soft UV-NIL), which comprises fabricating soft moulds from a master by cast moulding, and repeatedly replicating patterns with said soft moulds has gained attention.

Polydimethylsiloxane (PDMS) based materials have served as materials of choice in soft-lithography; actually the use of these soft, elastomeric materials offer numerous attractive properties: high transparency to UV-rays, low Young's modulus. Nevertheless, certain inherent properties of **PDMS** materials (e.g. too low Young's modulus causing moulds distortion, sagging and bending of patterned features; too high a surface energy and swelling by organic molecules causing defects in patterns replications) represented the driving force to introduce fluorochemicals as antisticking surface treatment agents and/or as mould raw-materials alternative to PDMS.

Thus, document JP 2004351693 16.12.2004 describes the use of certain functional perfluoropolyether materials for coating of a Si mould, to be used for manufacturing polymeric patterns by imprint technology.

WO 2005/101466 (UNIVERSITY OF NORTH CAROLINA) 27.10.2005 discloses the use of fluorinated elastomer-based materials, in particular perfluoropolyether (PFPE)-based materials, for manufacturing soft moulds from suitable patterned masters, said moulds being used for imprinting on UV-curable photoresists patterns of said masters. In particular, a perfluoropolyether diacrylate compound of formula: 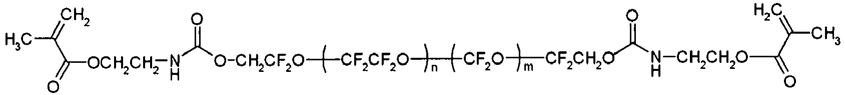 wherein the PFPE block has a molecular weight of about 3800 is disclosed.

Similarly, WILES, Kenton B., et al. Soft Lithography usinf perfluorinated polyether molds and PRINT technology for fabrication of 3-D arrays on glass substrates. Proceedings of the SPIE- The International Society for OpticalEngineering. 2006, vol.6151, p.61513F. disclose the use of photocured perfluorinated perfluoropolyether moulds for fabricating articles from curable precursors precisely replicating moulds' patterns.

Nevertheless, when applying these PFPE functional materials to the replication from masters having nanostructured patterns, it has been found that certain sagging and deformation problems in moulds having recesses or protrusion of sizes below 100 nm (e.g. 50 nm) might impair performances of moulds obtained therefrom in imprint technologies.

Document US 2008/000373 discloses the manufacture of soft mould to be used in nano-imprint lithography apparatuses starting from a negative pattern of a master, including submitting to actinic radiation a composition comprising fluorinated compounds securely bonded to a transparent support layer. The fluorinated compound can be notably a PFPE with molecular weight of 205 to 4000, preferably of 900 to 3000, more preferably of 900 to 2100 ; exemplified embodiments pertain to PFPE derivatives obtained by reacting a hydroxyl-derivative with acryloyl chloride.

Document EP1873174 discloses a photocurable polymer composition suitable for being employed for manufacturing a micro-pattern-formed cured product from a patterned master, said photocurable composition being based on hydrogenated monomers and fluorinated monomers. The polymer is typically a (meth)acrylic resin comprising recurring units derived from fluoro(meth)acrylates.

There is thus still a need in the art for an improved method for reproducing accurately and reliably (nano)patterns using flexible moulds, enabling suitable reproduction of features having nanometric sizes (e.g. 50 nm) and providing acceptable mould release properties, while being compatible with current technologies, including soft UV nanoimprint lithography, e.g. with standard masters (e.g. silicon masters) and standard plastics (e.g. photoresists).

### Disclosure of Invention

It is thus an object of the present invention a method for replicating a pattern, said method comprising:
(a) providing patterned template, wherein said patterned template comprises a patterned template surface having a plurality of recessed or protruded areas formed therein;
(b) contacting a volume of a curable perfluoropolyether composition [composition (C)] with said patterned template surface, said composition comprising:
   - at least one functional perfluoropolyether compound [compound (E)], said compound (E) comprising a (per)fluoropolyoxyalkylene chain [chain (R_{f})], wherein the molecular weight of said chain R_{f} is more than 1000 and less than 3500; and at least two unsaturated moieties; and
   - at least one photoinitiator;
(c) submitting to UV radiations said composition (C) to yield a mould comprising a patterned mould surface, and separating said mould from said patterned template;
(d) contacting said patterned mould surface with a (pre)polymer composition [composition (P)];
(e) processing said composition (P) to yield an article having a patterned surface, and separating said article from said mould, wherein said composition (P) comprises an inorganic filler having an average particle size of less than 1 µm.

The Applicant has found that by appropriate selection of the molecular weight of the chain R_{f} of the compound (E) is advantageously possible to obtain moulds which possess adequate mechanical and surface release properties to notably avoid pairing and sagging of moulds obtained therefrom, thus enabling advantageously substantially defect-free reproduction of patterns with a sub-50 nm resolution.

It has thus been found essential for the purposes of the invention for the molecular weight of the chain R_{f} to be comprised more than 1000 and less than 3500. It has been found that when the molecular weight of the chain R_{f} exceed said boundaries, then the shaped moulds obtained therefrom are endowed with unsatisfactory Young modulus: in other words, moulds are too soft and undergo sagging and pairing in patterned features, so that replication of master's features is inaccurate or even impossible, in particular when targeting resolution of below 50 nm.

On the contrary, when molecular weight of chain R_{f} decreases below above cited boundaries, then fluorinated weight fraction correspondently decreases with respect to hydrogenated functional moieties: as a consequence, surface energy and mould release properties are affected and issues in detaching both soft moulds from masters (with consequent risks in damaging said masters) and from patterned final parts occur.

For the avoidance of doubt, the term "(per)fluoropolyoxyalkylene chain (chain R_{f})" is hereby intended to denote a chain comprising recurring units (R1), said recurring units having general formula: -(CF₂)ₖ-CFZ-O-, wherein k is an integer of from 0 to 3 and Z is selected between a fluorine atom and a C₁-C₅ perfluoro(oxy)alkyl group.

Chain R_{f} preferably complies with formula: -(CF₂O)ₚ(CF₂CF₂O)_{q}(CFYO)ᵣ (CF₂CFYO)ₛ-(CF₂(CF₂)_{z}CF₂I)ₜ-
wherein Y is a C₁-C₅ perfluoro(oxy)alkyl group, z is 1 or 2; and p, q, r, s, t are integers ≥ 0, selected such that the molecular weight of said chain R_{f} complies with above mentioned requirements.

Chain R_{f} more preferably complies with formula:

-(CF₂O)ₚ(CF₂CF₂O)_{q}-

wherein p' and q' are integers ≥ 0, selected such that the molecular weight of said chain R_{f} complies with above mentioned requirements.

Preferably, the molecular weight of said chain R_{f} is between 1200 and 3500, more preferably between 1200 and 3000, still more preferably between 1500 and 3000, even more preferably between 1500 and 2500; it is thus understood that in corresponding preferred structures as above detailed p, q, r, s, t, p' and q' represent integers selected so as to comply with these molecular weight requirements.

Unsaturated moieties of the compound (E) are not particularly restricted provided that they possess a suitable reactivity in UV curing conditions.

Typically, compound (E) is selected among those of formula:

T₁-J-R_{f}-J'-T₂,

wherein R_{f} represents a chain R_{f} as above detailed, J and J', equal to or different from each other, are independently a bond or a divalent bridging group, and T₁ and T₂, equal to or different from each other, are selected from the group consisting of:
(A) -O-CO-CR_{H}=CH₂,
(B) -O-CO-NH-CO-CRH=CH₂,
(C)-O-CO-R^{A}-CR_{H}=CH₂,
wherein R_{H} is H or a C₁-C₆ alkyl group; R^{A} is selected from the group consisting of:
(j) -NH-R^{B}-O-CO-
(jj) -NH-R^{B}-NHCOO-R^{B}-OCO-;
R^{B} being a divalent group selected from the group consisting of C₁-C₁₀ aliphatic group, C₅-C₁₄ cycloaliphatic group; C₆-C₁₄ aromatic or alkylaromatic group.

Among preferred compounds (E) mention can be notably made of:
(1) acrylate-derivatives of formula: 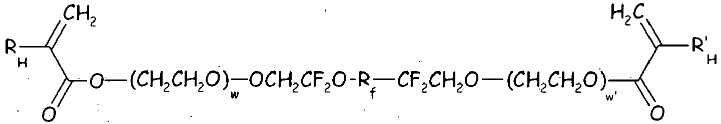 wherein w and w', equal to or different from each other, are independently an integer from 0 to 5, R_{f} representing a chain R_{f} as above detailed and R_{H} and R'_{H} being H or a C₁-C₆ alkyl group;
(2) acrylamide-urea derivatives of formula: 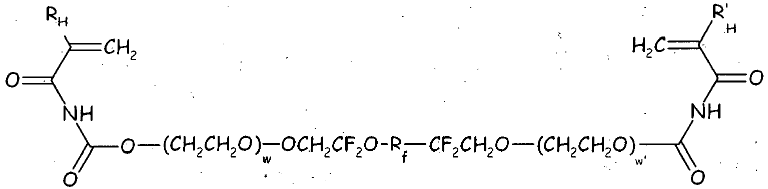 wherein w and w', R_{f}, and R_{H} and R'_{H} have same meaning as above detailed;
(3) acrylate-urethane derivatives of formula: 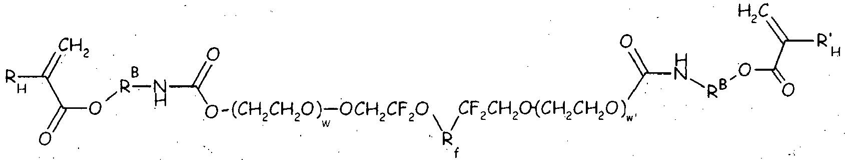 wherein w and w', R_{f}, RH and R'_{H} have same meaning as above detailed, and each of R^{B}, equal to or different from each other, is a divalent group selected from the group consisting of C₃-C₁₀ aliphatic group, C₅-C₁₄ cycloaliphatic group; C₆-C₁₄ aromatic or alkylaromatic group; and
(4) urethane-amide-acrylate derivatives of formula: 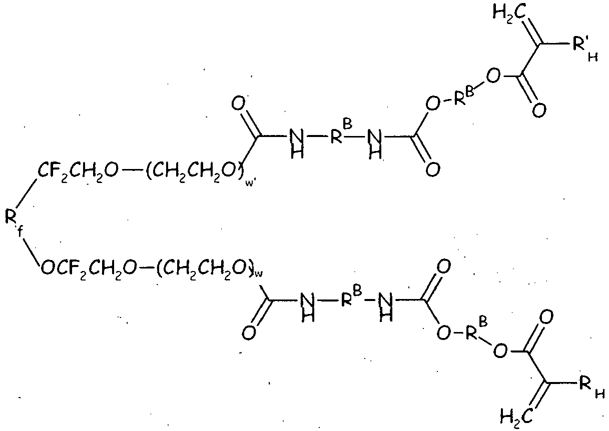 wherein w and w', R_{f} ,R^{B}, and R_{H} and R'_{H} have same meaning as above detailed.

Most preferred compounds (E) are those selected from the group consisting of:
(i) 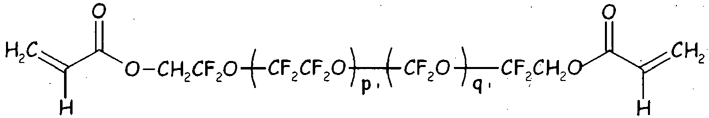
(ii) 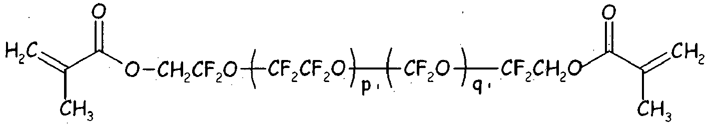
(iiii) 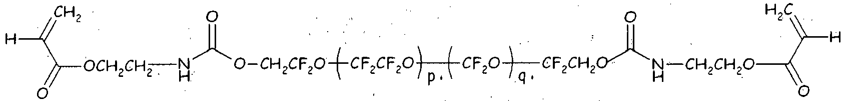
(iv) 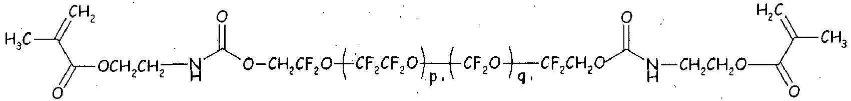
wherein in formulae here above p' and q' are selected so that the molecular weight of chain R_{f} is comprised in above mentioned boundaries.

The choice of the photoinitiator is not limited; all compounds enabling suitable generation of radicals under UV radiation will be suitable in the process of the invention.

It is generally understood that photoinitiators are generally selected from the group consisting of following families:
- alpha-hydroxyketones; among alpha-hydroxyketones, mention can be made of 1-hydroxy-cyclohexyl-phenyl-ketone; 2-hydroxy-2-methyl-1-phenyl-1-propanone; and 2-hydroxy-1-[4-(2-hydroxyethoxy)phenyl]-2-methyl-1-propanone;
- phenylglyoxylates; among phenylglyoxylates, mention can be made of methylbenzoylformate; oxy-phenyl-acetic acid 2-[2-oxo-2-phenyl-acetoxy-ethoxy]-ethyl ester, and oxy-phenyl-acetic 2-[2-hydroxy-ethoxy]-ethyl ester;
- benzyldimethyl-ketals; among benzyldimethyl-ketals, mention can be made of alpha, alpha-dimethoxy-alpha-phenylacetophenone;
- alpha-aminoketones; among alpha-aminoketones, mention can be made of 2-benzyl-2-(dimethylamino)-1-[4-(4-morpholinyl) phenyl]-1-butanone, and 2-methyl-1-[4-(methylthio)phenyl]-2-(4-morpholinyl)-1-propanone;
- bis acyl-phosphines; among bis acyl-phosphines, mention can be made of diphenyl-(2,4,6-trimethylbenzoyl)-phosphine oxide.

Among photoinitiators, those which are liquid at room temperature are preferred.

A class of photoinitiators which gave particularly good results has been that of alpha-hydroxyketones, in particular
2-hydroxy-2-methyl-1-phenyl-1-propanone.

The amount of photoionitiator is not particularly limited. Generally, it will be used in an amount of at least 0.01 % wt, preferably of 0.05 % wt, more preferably of 0.1 % wt, with respect to the weight of the compound (E).

Also, said photoinitiator is generally used in an amount of at most 10 % wt, preferably at most 7.5 % wt, more preferably at most 5 % wt, with respect to the weight of the compound (E).

In particular, as residues from photoinitiator might possibly impair durability of moulds, it is generally preferred to minimize amount as much as possible photoinitiator.

The composition (C) might possibly comprise further additives and ingredients, like notably thermal stabilizers, antioxidants, viscosity modifiers, and the like.

It is nevertheless generally understood that compound (E) is the major component of the composition (C); minor amounts of other components might be present to the extent that they do not modify properties of said compound (E).

Step (c) of the process of the invention, i.e. submitting to UV radiations composition (C) is carried out according to standard methods; UV radiations employed generally have a wavelength in the range of from 200 nm to 350 nm.

Among sources of UV radiations which can be used, mention can be made of mercury lamps, xenon arc lamps (commonly used as sunlight simulators), deuterium arc lamps, mercury-xenon arc lamps, mental-halide arc lamps, and tungsten-halogen incandescent lamps.

Radiation dose will be adjusted by the skilled in the art as a function of the type and concentration of photoinitiator; generally, good results have been obtained with radiation doses of at least 2 J/cm², preferably 5 J/cm².

It is also preferred for achieving improved curing rates and minimizing degradation reactions to submit composition (C) to UV radiations in step (c) under a substantially oxygen-free atmosphere. Typically step (c) will be carried out under nitrogen atmosphere.

Cured soft moulds are then advantageously separated from the template.

It may be useful to treat the patterned template (otherwise called master) with suitable surface treating agents. Among them fluoro-compounds containing silane moieties can be used. Mention can be notably made of certain fluorinated silanes, such as trichloro-(1H,1H, 2H, 2H-perfluorooctyl)silane, (3-trichlorosilyl)propylmethacrylate, or of certain functional (per)fluoropolyether having silane moities (e.g. FLUOROLINK® S10, commercially available from Solvay Solexis S.p.A).

Nevertheless, the use of said surface treatment agents is not typically

The method of the invention comprises:
(d) contacting said patterned mould surface with a (pre)polymer composition [composition (P)], comprising inorganic filler as above detailed; (e) processing said composition (P) to yield an article having a patterned surface, and separating said article from said mould.

The pattern of the patterned mould surface obtained from step (C) of the process of the present invention is advantageously a negative replication of the pattern of the patterned template surface.

The pattern of the article patterned surface as obtained in step (e) of the process of the present invention is advantageously a replication of the pattern of the patterned template surface.

The selection of the (pre)polymer composition is not particularly limited and will be selected taking into account the particular processing technique to be used. Either thermoplastic or thermosetting/curable (pre)polymer composition (P) can be used.

In case of thermoplastic (pre)polymer compositions, in step (d) it can be possible to generate patterned structure in the article by using a suitable solvent which can dissolve or soften the composition (P) without affecting the mould. Thus, according to this embodiment, the mould can be contacted or wetted with said solvent and then contacted with the surface of a substrate of composition (P). Said solvent is generally understood to dissolve or swell a thin layer of said composition (P) substrate, and said softened or gelled layer is moulded against the patterned surface of the mould. Dissipation and/or evaporation of the solvent during processing in step (e) advantageously enable obtaining a solid article having patterned surface complementary to the surface of the mould, thus replicating template pattern.

Still in case of thermoplastic (pre)polymer compositions, in step (d) and (e) it can be possible to generate patterned structure in the article by imprinting the pattern of the mould into the thermally softened composition (P).

Embodiments wherein composition (P) is thermosetting/curable are generally preferred.

Embodiments wherein composition (P) is thermosetting/curable are generally preferred.

According to these embodiments, composition (P), typically in liquid form, is generally applied to the patterned surface of the mould by standard casting techniques. Non limitative examples of said techniques are notably spinning, spraying, knife casting. The composition (P) is then processed in step (e) by curing as a solid by irradiation and/or by heating.

UV-curable compositions (P) are preferred. In step (e), processing comprises thus irradiating with UV radiation the composition (P) Those compositions, which are also often referred to as photoresists, are not particularly limited.

UV-curable (pre)polymer composition (P) generally comprises at least one photoreactive monomer or oligomer and a photoinitiator.

Said photoreactive monomer or oligomer generally comprise one or more of (meth)acryloyl and epoxy functions. Monofunctional, difunctional, tri- or multifunctional derivatives can be used.

The (meth)acrylate monomer or oligomer having at least one (meth)acryloyl group may be a fluorinated or nonfluorinated (meth)acrylate.

The monofunctional fluorinated (meth)acrylate includes 2-perfluorooctylethyl acrylate, 2-perfluorooctylethyl methacrylate, 2,2, 3, 4,4, 4-hexafluorobutyl methacrylate, 2, 2, 3, 3-tetrafluoropropyl methacrylate, trifluoroethyl methacrylate, 2-perfluoroallcylethyl acrylate and 2-perfluoroalkylethyl methacrylate.

Representative examples of the monofunctional nonfluorinated (meth)acrylate are (3-methacryloxypropyl)trimethoxysilane, (3-methacryloxypropyl)dimethylmethoxysilane, (3-acryloxypropyl)-trimethoxysilane, 2-hydroxyethyl-(meth)acrylate, 2-hydroxypropyl-(meth) acrylate, 2-hydroxybutyl-(meth)acrylate, 1-hydroxybutyl-(meth)acrylate, 2-hydroxy-3-phenyloxypropyl(meth) acrylate, tetrahydrofurfuryl-(meth)acrylate, isodecyl-(meth)acrylate, 2-(2-ethoxyethoxy)-ethyl-(meth)acrylate, stearyl(meth)acrylate, lauryl(meth)acrylate, 2-phenoxyethyl(meth)acrylate, isobornyl(meth)acrylate, tridecyl(meth)acrylate, polycarprolactone(meth)acrylate, phenoxytetraethyleneglycol-(meth) acrylate and imide-acrylate.

The difunctional nonfluorinated (meth)acrylate which may be employed in the present invention may be ethoxylated-nonylphenol(meth)acrylate, ethylene glycol di(meth)acrylate, diethylene glycol di(meth)acrylate, triethylene glycol di(meth)acrylate, tetraethylene glycol di(meth)acrylate, polyethylene glycol di(meth)acrylate, 1,6-hexanediol di(meth)acrylate, 1,3-butylene glycol di(meth)acrylate, tripropylene glycol di(meth)acrylate, ethoxylated bisphenol A di(meth)acrylate, cyclohexane dimethanol di(meth)acrylate.

Preferred examples of the tri-or multi-functional nonfluorinated (meth)acrylate are tris[2-(acryloyloxy)ethyl]isocyanurate, trimethylol propane triacrylate, ethylene oxide added trimethylol propane triacrylate, pentaerythritol triacrylate, tris(acrylooxyethyl)isocyanurate, dipentaerythritol hexaacrylate and caprolactone denatured dipentaerythritol hexaacrylate.

Representative examples of the epoxy monomer or oligomer having at least one epoxy group include (3-glycidyloxypropyl)triethoxysilane, 3,4-epoxycyclohexylmethyl-3, 4-epoxy cyclohexane carboxylate, bis- (3, 4-epoxycyclohexyl) adipate, 3-ethyl-3-hydroxymethyl-oxetane, 1, 2-epoxyhexadecane, alkyl glycidyl ether, 2-ethyl hexyl diglycol glycidyl ether, ethyleneglycol diglycidyl ether, diethyleneglycol diglycidyl ether, PEG#200 diglycidyl ether, PEG#400 diglycidyl ether, propyleneglycol diglycidyl ether, tripropyleneglycol diglycidyl ether, PPG#400 diglycidyl ether, neopentylglycol diglycidyl ether, 1,6-hexanediol diglycidyl ether, hydrogenated bisphenol A diglycidyl ether, diglycidyl ether of propyleneoxide modified bisphenol A, dibromo neopentylglycol diglycidyl ether and trimethylolpropane triglycidyl ether.

Preferred photoreactive monomers or oligomers are those comprising sil(ox)ane moieties; among these preferred compounds, mention can be made of (3-glycidyloxypropyl)triethoxysilane, (3-methacryloxypropyl)trimethoxysilane, (3-methacryloxypropyl)dimethylmethoxysilane, (3-acryloxypropyl)-trimethoxysilane.

Good results have been obtained when using
(3-methacryloxypropyl)trimethoxysilane.

As per the photoinitiator, same photoinitiators as those described for composition (C) can be used.

Composition (P) can further comprise additional additives and ingredients.

In particular, composition (P) comprises inorganic fillers having sub-micron or nanometric sizes. Thus, the composition (P) comprises inorganic filler having an average particle size of less than 1 µm, preferably of less than 500 nm, more preferably of less than 50 nm.

Said inorganic fillers are advantageously selected among inorganic oxides, like notably, SiO₂, TiO₂, ZrO₂, Al₂O₃ and mixed oxides therefrom. Silica particles are particularly advantageous.

For replicating patterns having structures features of less than 50 nm, SiO₂ and/or ZrO₂ particles having average sizes comprised between 1 and 15 nm can be advantageously used.

The invention will be now described with reference to the following examples, whose purpose is merely illustrative and not intended to limit the scope of the invention.

### EXAMPLES

### Preparative example 1: Synthesis of a functional PFPE compound with R_{f} having M_{w} of 1600

In a 0.5 I flask, equipped with a mechanical stirrer, a dropping funnel and a refrigeration column, 250 g of an hydroxyl-PFPE derivative of formula: HOCH₂CF₂O(CF₂CF₂O)ₚ(CF₂O)_{q}OCF₂CH₂OH, wherein p and q are integers such that the a average molecular weight is 1600 (0.3 eq), 0.03 g of 3,5-di-tert-butyl-4-hydroxytoluene (BHT), 0.5 ml of a 20% (w/v) solution of tin dibutyidilaurate in 2-Butanone (MEK) were introduced under inert atmosphere and the temperature was raised up to 50 °C. Under nitrogen, 46.5 g of 2-isocyanatoethyl methacrylate (EIM, MW= 155; 0.3 eq) were slowly dropped, while maintaining the reaction temperature below 60°C and the mixture was then kept under stirring for 2 hrs. The reaction was followed by means of FT-IR analysis, monitoring the disappearance of absorption at 2250 cm⁻¹ typical of the isocyanate band, and by means of ¹⁹F-NMR, evaluating the shifts of the signals of the preterminal CF₂ groups from -81.3 ppm and of -83.3 ppm when linked to the CF₂CH₂OH group to -77.5 and -79.5 ppm when bounded to the urethane moiety. Upon filtration through a 0.2 µm PTFE membrane, 292 g of a functional PFPE compound complying with formula: 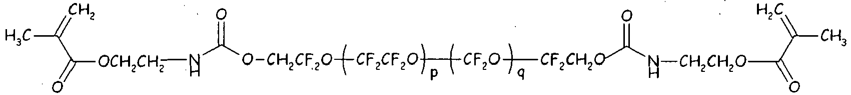 , with p and q being as above, were then recovered with 98.5 yield.

### Preparative example 2: Synthesis of a functional PFPE compound with R_{f} having M_{w} of 3817

Same procedure as described in example 1, but using as hydroxyl PFPE precursor 250 g of a derivative of formula HOCH₂CF₂O(CF₂CF₂O)ₚ(CF₂O) _{q}OCF₂CH₂OH, with p'/q'=0.9, p' and q 'being such that the M_{w} is 3817 (0.127 eq) and 19.7g of 2-isocyanatoethyl methacrylate (EIM, MW= 155; 0.3 eq). 263 g of a functional PFPE compound complying with formula: 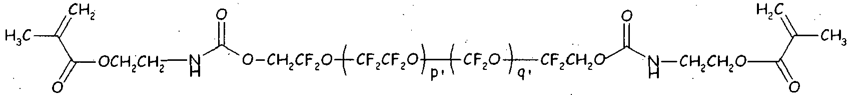 , with p' and q' being as above, were obtained with 97.5 % yield.

### Test for patterns replication

### Manufacture of patterned templates:

The test design for micro-pattern replication containing pads with size ranging from 100 µm x 100 µm down to 2 µm x 2 µm was defined by optical contact lithography. Nano-gratings with period both 500 and 180 nm were defined by laser interference lithography. 50 nm periodic hole-arrays with a diameter of 30 nm were defined using electron beam writer. The defined micro-and nano-patterns were transferred into the silicon substrate by reactive ion etch (RIE). A thin standard anti-adhesion layer was coated onto the surface of all prepared masters to prevent mechanical damage of the topography during flexible mould manufacture.

### Preparation of flexible moulds:

Flexible moulds were prepared by cast moulding compositions on masters having patterned features obtained as above detailed. Thus, composition comprising required functional PFPE derivative and appropriate amount of 2-hydroxy-2-methyl-1-phenyl-1-propanone (commercially available under trade name DAROCUR^{®} 1173 from Ciba Specialty Chemicals). After degassing, the precursor was cured by UV-exposure (Hg lamp) with a dose of 10 Jcm⁻² under N₂ atmosphere and the flexible mould so obtained was separated from the master.

Comparative runs were carried out preparing flexible moulds from standard PDMS derivatives; thus SYLGARD^{®} 184 material from Dow Corning was mixed with prescribed thermal curing agent and thermally cured at 120°C for 30 minutes.

### Replication of patterns:

Flexible moulds obtained as above detailed were pressed onto a pre-polymer layer comprising 3-methacryloxypropyltrimethoxysilane, 2-benzyl-2-(dimethylamino)-1-[4-(4-morpholinyl) phenyl]-1-butanone (IRGACURE^{®} 369) and a finely divided inorganic filler (SiO₂ and ZrO₂ having particle sizes of less than 10 nm), using an imprint tool EVG 620. The cavities of flexible moulds were filled with said pre-polymer and cured by UV-exposure with a dose of 2 Jcm⁻². After separation of the soft moulds, micro-and nano-replications were evaluated by electron microscopy.

### Results are summarized here below.

### Example 3 Replication of 500 nm periodic gratings with a line-width of 150 nm

Results are summarized in table 1 here below:

**Table 1**

| Run | mould precursor | Initiator | Resolution in imprinted patterns | Fidelity in imprinted patterns | SEM picture of imprinted patterns |
|---|---|---|---|---|---|
| A | ex. 1 | 4%wt | excellent | excellent | Figure 1 |
| B | PDMS | | good | poor | Figure 2 |
| (comparison) | | | | | |
| C (comparison) | ex. 2 | 2%wt | excellent | acceptable | Not available |

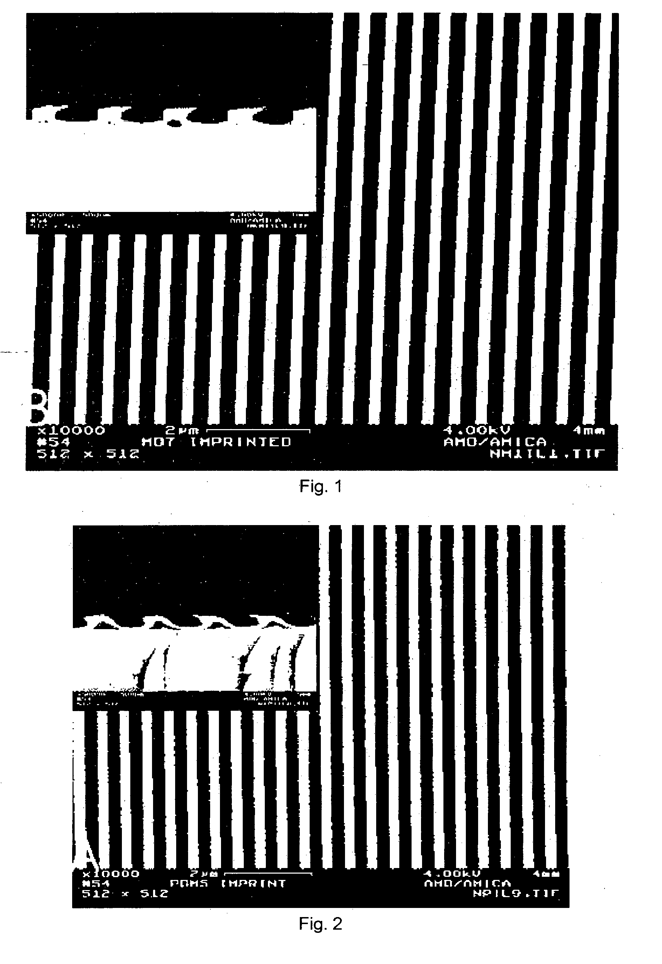

As apparent from comparison of Figure 1 and 2, in particular cross-section views, well demonstrate that only PFPE moulds enable adequate replication of side-wall profiles in imprinted patterns.

### Example 4 Replication of 50 nm periodic holes with 29 nm diameter

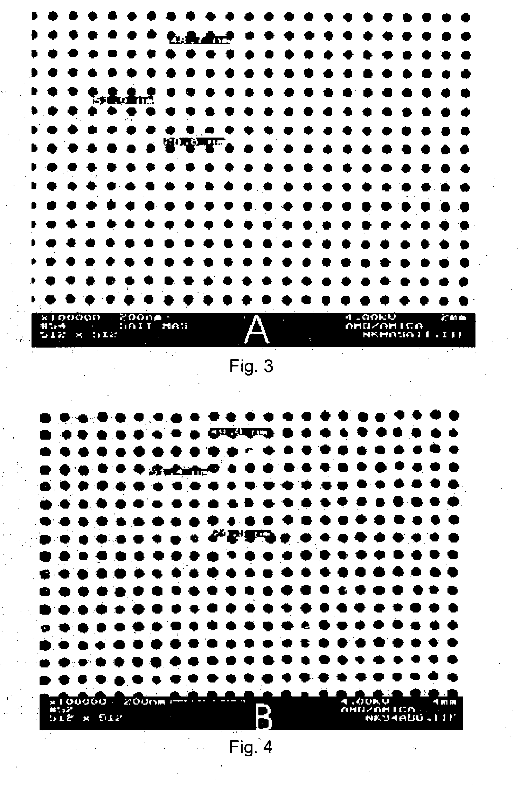

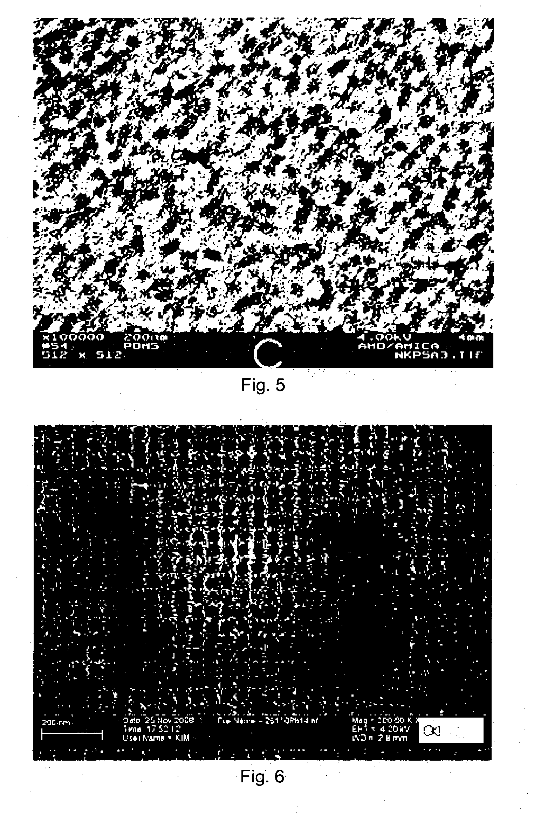

A silicon master including 50 nm periodic holes (see figure 3) with a diameter of 29 nm and spaces of 20 nm was used for fabrication of imprinted patterns.

Results are summarized in table 1 here below:

**Table 2**

| Run | mould precursor | Initiator | Resolution in imprinted patterns | SEM picture of imprinted patterns |
|---|---|---|---|---|
| A | ex. 1 | 4%wt | excellent | Figure 4 |
| B (comparison ) | PDMS | | none | Figure 5 |
| C (comparison ) | ex. 2 | 2%wt | poor | Figure 6 |

Comparison between results obtained in runs 4A and 4C well demonstrate that only the PFPE material complying with the molecular weight requirements of the present invention actually enables achievement of pattern resolution down to 30 nm, wherein higher molecular weight analogous have been found to fail.

## Claims

1. A method for replicating a pattern, said method comprising:
(a) providing patterned template, wherein said patterned template comprises a patterned template surface having a plurality of recessed or protruded areas formed therein;
(b) contacting a volume of a curable perfluoropolyether composition [composition (C)] with said patterned template surface, said composition comprising:
- at least one functional perfluoropolyether compound [compound (E)], said compound (E) comprising a (per)fluoropolyoxyalkylene chain [chain (R_{f})], wherein the molecular weight of said chain R_{f} is more than 1000 and less than 3500; and at least two unsaturated moieties; and
- at least one photoinitiator;
(c) submitting to UV radiations said composition (C) to yield a mould comprising a patterned mould surface, and separating said mould from said patterned template;
(d) contacting said patterned mould surface with a (pre)polymer composition [composition (P)];
(e) processing said composition (P) to yield an article having a patterned surface, and separating said article from said mould, wherein said composition (P) comprises an inorganic filler having an average particle size of less than 1 µm.

2. The method according to the preceding claim, wherein compound (E) is selected among those of formula:
T₁-J-R_{f}-J'-T₂,
wherein R_{f} represents a (per)fluoropolyoxyalkylene chain, J and J', equal to or different from each other, are independently a bond or a divalent bridging group, and T₁ and T₂, equal to or different from each other, are selected from the group consisting of:
(A)-O-CO-CR_{H}=CH₂,
(B) -O-CO-NH-CO-CR_{H}=CH₂,
(C) -O-CO-RA-CR_{H}=CH₂,
wherein R_{H} is H or a C₁-C₆ alkyl group; R^{A} is selected from the group consisting of:
(j) -NH-R^{B}-O-CO-
(jj) -NH-R^{B}-NHCOO-R^{B}-OCO-;
R^{B} being a divalent group selected from the group consisting of C₁-C₁₀ aliphatic group, C₅-C₁₄ cycloaliphatic group; C₆-C₁₄ aromatic or alkylaromatic group.

3. The method according to anyone of the preceding claims, wherein said chain R_{f} complies with formula: -(CF₂O)ₚ(CF₂GF₂O)_{q}(CFYO)ᵣ(CF₂CFYO)ᵣ(CF₂(CF₂)_{z} CF₂O)ₜ-
wherein Y is a C₁-C₅ perfluoro(oxy)alkyl group, z is 1 or 2; and p, q, r, s, t are integer ≥ 0, selected such that the molecular weight of said chain R_{f} is more than 1000 and less than 3500.

4. The method according to Claim 4, wherein compound (E) is selected from the group consisting of :
(1) acrylate-derivatives of formula: 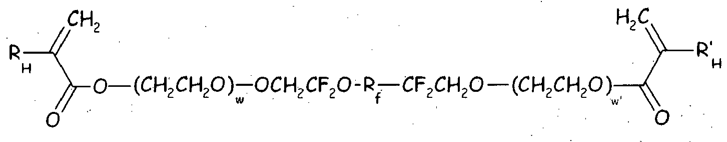 wherein w and w', equal to or different from each other, are independently an integer from 0 to 5, R_{f} representing a chain R_{f} as detailed in claim 4 and R_{H} and R'_{H} being H or a C₁-C₆ alkyl group;
(2) acrylamide-urea derivatives of formula: 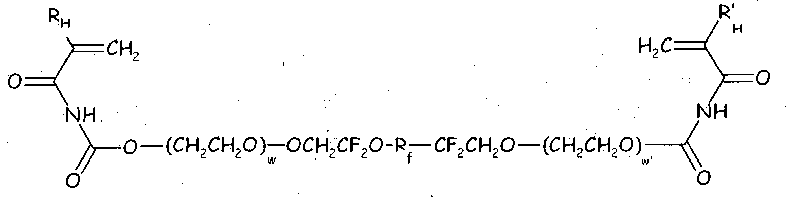 wherein w and w', R_{f}, and R_{H} and R'_{H} have same meaning as above detailed;
(3) acrylate-urethane derivatives of formula: 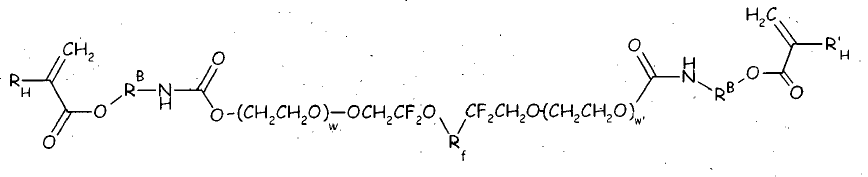 wherein w and w', R_{f}, R_{H} and R'_{H} have same meaning as above detailed, and each of R^{B}, equal to or different from each other, is a divalent group selected from the group consisting of C₃-C₁₀ aliphatic group, C₅-C₁₄ cycloaliphatic group; C₆-C₁₄ aromatic or alkylaromatic group; and
(4) urethane-amide-acrylate derivatives of formula: 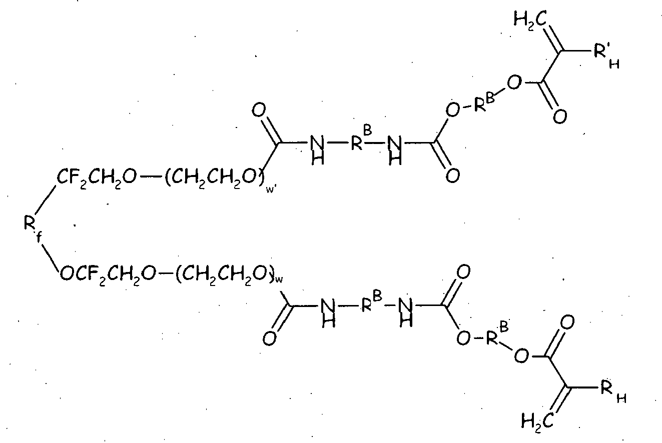 wherein w and w', R_{f}, R^{B}, R_{H} and R'_{H} have same meaning as above detailed.

5. The method according to Claim 4, wherein compound (E) is selected from the group consisting of:
(i) 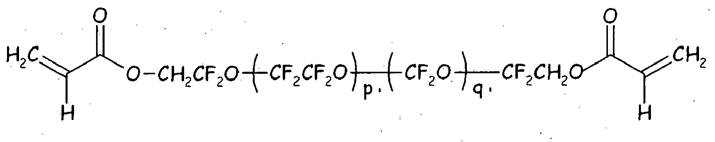
(ii) 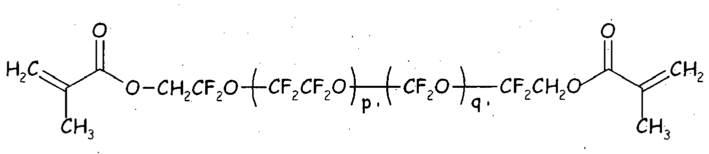
(iiii) 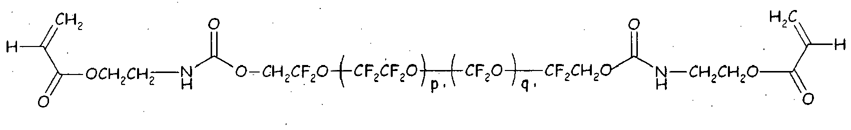
(iv) 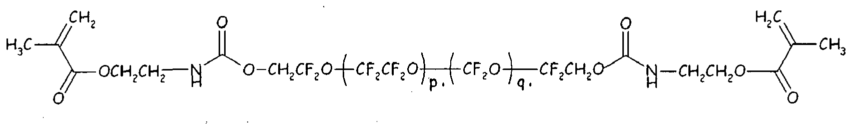 wherein in formulae here above p' and q' are selected so that the molecular weight of said chain R_{f} is more than 1000 and less than 3500, preferably is comprised between 1200 and 3000, more preferably between 1500 and 2500.

6. The method according to anyone of the preceding claims, wherein the photoinitiator is selected from the group consisting of following families:
- alpha-hydroxyketones;
- phenylglyoxylates;
- benzyldimethyl-ketals;
- alpha-aminoketones;
- bis acyl-phosphines.

7. The method according to anyone of the preceding claims, wherein the photoinitiatos is selected from the group consisting of:
- alpha-hydroxyketones selected from the group consisting of
1-hydroxy-cyclohexyl-phenyl-ketone;
2-hydroxy-2-methyl-1-phenyl-1-propanone; and
2-hydroxy-1-[4-(2-hydroxyethoxy)phenyl]-2-methyl-1-propanone;
- phenylglyoxylates selected from the group consisting of
methylbenzoylformate; oxy-phenyl-acetic acid
2-[2-oxo-2-phenyl-acetoxy-ethoxy]-ethyl ester, and oxy-phenyl-acetic
2-[2-hydroxy-ethoxy]-ethyl ester;
- alpha, alpha-dimethoxy-alpha-phenylacetophenone;
- alpha-aminoketones selected from the group consisting of
2-benzyl-2-(dimethylamino)-1-[4-(4-morpholinyl) phenyl]-1-butanone, and
2-methyl-1-[4-(methylthio)phenyl]-2-(4-morpholinyl)-1-propanone; and
- diphenyl-(2,4,6-trimethylbenzoyl)-phosphine oxide.

8. The method according to anyone of the preceding claims, wherein the composition (C) is submitted to UV radiations in step (c) under a substantially oxygen-free atmosphere.

9. The method according to anyone of the preceding claims, wherein the radiation dose in step (c) is of at least 2 J/cm², preferably 5 J/cm².

10. The method according to anyone of the preceding claims, wherein (pre)polymer composition (P) is thermoplastic or thermosetting/curable.

11. The method according to Claim 10, wherein composition (P) is thermosetting/curable and wherein in step (d) composition (P) is applied to the patterned surface of the mould by casting techniques and then processed in step (e) by curing by irradiation and/or by heating.

12. The method according to Claim 11, wherein a UV-curable composition (P) is used and wherein in step (e), processing comprises irradiating with UV radiation said UV-curable composition (P).

13. The method of Claim 12, wherein the UV-curable (pre)polymer composition (P) comprises at least one photoreactive monomer or oligomer and a photoinitiator.

14. The method of Claim 13, wherein the photoreactive monomers or oligomers are selected from the group consisting of (3-glycidyloxypropyl)triethoxysilane, (3-methacryloxypropyl)trimethoxysilane, (3-methacryloxypropyl)dimethylmethoxysilane, (3-acryloxypropyl)-trimethoxysilane.

15. The method according to anyone of the preceding claims, wherein said composition (P) comprises SiO₂ and/or ZrO₂ particles having average sizes comprised between 1 and 15 nm.

## Patentansprüche

1. Verfahren zum Replizieren einer Struktur, wobei das Verfahren umfasst:
(a) Bereitstellen eines strukturierten Templats, wobei das strukturierte Templat eine strukturierte Templatoberfläche umfasst, die eine Vielzahl von darin gebildeten vertieften oder erhöhten Bereichen aufweist;
(b) Inkontaktbringen eines Volumens einer härtbaren Perfluorpolyetherzusammensetzung [Zusammensetzung (C)] mit der strukturierten Templatoberfläche, wobei die Zusammensetzung umfasst:
- wenigstens eine funktionelle Perfluorpolyetherverbindung [Verbindung (E)], wobei die Verbindung (E) eine (Per)fluorpolyoxyalkylenkette [Kette (R_{f})], wobei das Molekulargewicht der Kette R_{f} mehr als 1000 und weniger als 3500 beträgt, und wenigstens zwei nichtgesättigte Einheiten umfasst; und
- wenigstens einen Photoinitiator;
(c) Exponieren der Zusammensetzung (C) gegenüber UV-Strahlung, um eine Gussform zu erhalten, die eine strukturierte Gussform-Oberfläche aufweist, und Trennen der Gussform von dem strukturierten Templat;
(d) Inkontaktbringen der strukturierten Gussform-Oberfläche mit einer (Prä)polymerzusammensetzung [Zusammensetzung (P)];
(e) Verarbeiten der Zusammensetzung (P), um einen Gegenstand mit einer strukturierten Oberfläche zu erhalten, und Trennen des Gegenstands von der Gussform, wobei die Zusammensetzung (P) einen anorganischen Füllstoff mit einer mittleren Partikelgröße von weniger als 1 µm umfasst.

2. Verfahren gemäß dem vorstehenden Anspruch, wobei die Verbindung (E) ausgewählt ist aus jenen der Formel:
T₁-J-R_{f}-J'-T₂,
wobei R_{f} eine (Per)fluorpolyoxyalkylenkette darstellt, J und J', die gleich oder
voneinander verschieden sind, unabhängig eine Bindung oder eine zweiwertige verbrückende Gruppe sind, und T₁ und T₂, die gleich oder voneinander verschieden sind, ausgewählt sind aus der Gruppe bestehend aus:
(A) -O-CO-CR_{H}=CH₂,
(B) -O-CO-NH-CO-CR_{H}=CH₂,
(C) -O-CO-R^{A}-CR_{H}=CH₂,
wobei R_{H} H oder eine C₁-C₆-Alkylgruppe ist; R^{A} ausgewählt ist aus der Gruppe bestehend aus:
(j) -NH-R^{B}-O-CO-,
(jj) -NH-R^{B}-NHCOO-R^{B}-OCO-;
wobei R^{B} eine zweiwertige Gruppe ausgewählt aus der Gruppe bestehend aus einer C₁-C₁₀-aliphatischen Gruppe, C₅-C₁₄-cycloaliphatischen Gruppe; C₆-C₁₄-aromatischen oder alkylaromatischen Gruppe ist.

3. Verfahren gemäß einem der vorstehenden Ansprüche, wobei die Kette R_{f} der Formel: -(CF₂O)ₚ(CF₂CF₂O)_{q}(CFYO)ᵣ(CF₂CFYO)ₛ-(CF₂(CF₂)_{z}CF₂O)ₜ-entspricht,
wobei Y eine C₁-C₅-Perfluor(oxy)alkylgruppe ist, z 1 oder 2 ist; und p, q, r, s, t ganze Zahlen ≥ 0 sind, so ausgewählt, dass das Molekulargewicht der Kette R_{f} größer als 1000 und kleiner als 3500 ist.

4. Verfahren gemäß Anspruch 3, wobei die Verbindung (E) ausgewählt ist aus der Gruppe bestehend aus:
(1) Acrylatderivaten der Formel: 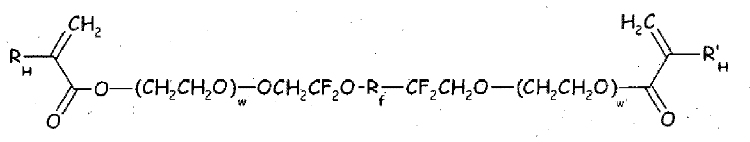 wobei w und w', die gleich oder voneinander verschieden sind, unabhängig eine ganze Zahl von 0 bis 5 sind, R_{f} eine wie in Anspruch 3 beschriebene Kette R_{f} darstellt und R_{H} und R'_{H} H oder eine C₁-C₆-Alkylgruppe sind;
(2) Acrylamid-Harnstoff-Derivaten der Formel: 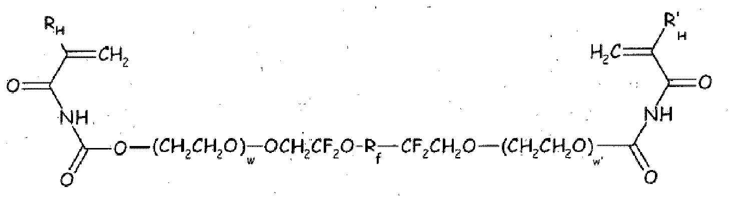 wobei w und w', R_{f} und R_{H} und R'_{H} die wie vorstehend beschriebene Bedeutung haben;
(3) Acrylamid-Urethan-Derivaten der Formel: 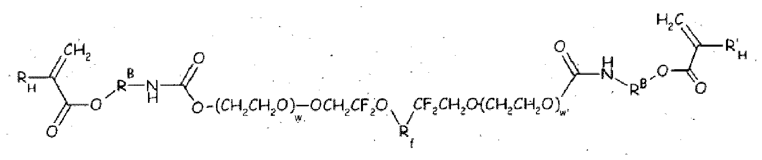 wobei w und w', R_{f} und R_{H} und R'_{H} die wie vorstehend beschriebene Bedeutung haben und jedes R^{B}, die gleich oder voneinander verschieden sind, eine zweiwertige Gruppe ausgewählt aus der Gruppe bestehend aus einer C₃-C₁₀-aliphatischen Gruppe, C₅-C₁₄-cycloaliphatischen Gruppe; C₆-C₁₄-aromatischen oder alkylaromatischen Gruppe ist; und
(4) Urethan-Amid-Acrylat-Derivaten der Formel: 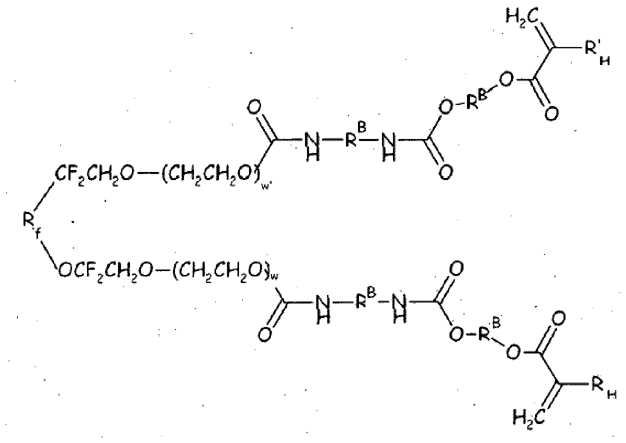 wobei w und w', R_{f}, R^{B}, R_{H} und R'_{H} die wie vorstehend beschriebene Bedeutung haben.

5. Verfahren gemäß Anspruch 4, wobei die Verbindung (E) ausgewählt ist aus der Gruppe bestehend aus:
(i) 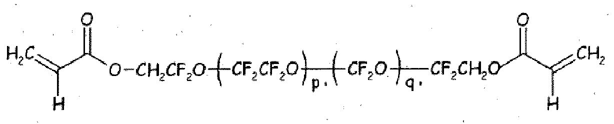
(ii) 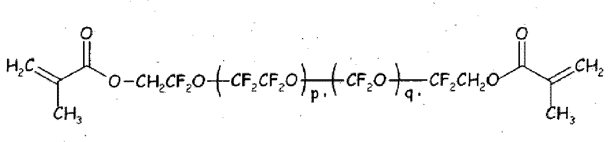
(iiii) 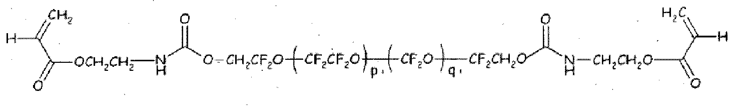
(iv) 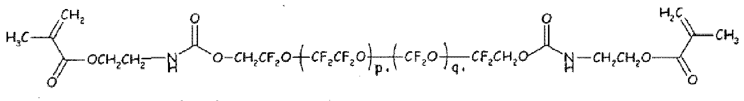 wobei in den vorstehenden Formeln p' und q' so ausgewählt sind, dass das Molekulargewicht der Kette R_{f} mehr als 1000 und weniger als 3500 beträgt, vorzugsweise in dem Bereich zwischen 1200 und 3000 liegt, bevorzugter zwischen 1500 und 2500.

6. Verfahren gemäß einem der vorstehenden Ansprüche, wobei der Photoinitiator ausgewählt ist aus der Gruppe bestehend aus folgenden Familien:
- alpha-Hydroxyketonen;
- Phenylglyoxylaten;
- Benzyldimethylketalen;
- alpha-Aminoketonen;
- Bisacylphosphinen.

7. Verfahren gemäß einem der vorstehenden Ansprüche, wobei der Photoinitiator ausgewählt ist aus der Gruppe bestehend aus:
- alpha-Hydroxyketonen ausgewählt aus der Gruppe bestehend aus
1-Hydroxycyclohexylphenylketon;
2-Hydroxy-2-methyl-1-phenyl-1-propanon; und
2-Hydroxy-1-[4-(2-hydroxyethoxy)phenyl]-2-methyl-1-propanon;
Phenylglyoxylaten ausgewählt aus der Gruppe bestehend aus
Methylbenzo ylformiat;
Oxyphenylessigsäure
2-[2-Oxo-2-phenylacetoxyethoxy]ethylester und
Oxyphenylessigsäure-2-[2-hydroxyethoxy]ethylester;
alpha,alpha-Dimethoxy-alpha-phenylacetophenon;
alpha-Aminoketonen ausgewählt aus der Gruppe bestehend aus
2-Benzyl-2-(dimethylamino)-1-[4-(4-morpholinyl)phenyl]-1-butanon und
2-Methyl-1-[4-(methylthio)phenyl]-2-(4-morpholinyl)-1-propanon; und
Diphenyl-(2,4,6-trimethylbenzoyl)phosphinoxid.

8. Verfahren gemäß einem der vorstehenden Ansprüche, wobei die Zusammensetzung (C) bei Schritt (c) unter einer im Wesentlichen sauerstofffreien Atmosphäre gegenüber UV-Strahlung exponiert wird.

9. Verfahren gemäß einem der vorstehenden Ansprüche, wobei die Strahlendosis bei Schritt (c) wenigstens 2 J/cm² beträgt, vorzugsweise 5 J/cm².

10. Verfahren gemäß einem der vorstehenden Ansprüche, wobei die (Prä)polymerzusammensetzung (P) thermoplastisch oder wärmehärtend/härtbar ist.

11. Verfahren gemäß Anspruch 10, wobei die Zusammensetzung (P) wärmehärtend/härtbar ist und wobei bei Schritt (d) die Zusammensetzung (P) durch Gießverfahren auf die strukturierte Oberfläche der Gussform aufgebracht und dann bei Schritt (e) durch Härten durch Bestrahlung und/oder durch Erhitzen verarbeitet wird.

12. Verfahren gemäß Anspruch 11, wobei eine UV-härtbare Zusammensetzung (P) verwendet wird und wobei bei Schritt (e) die Verarbeitung Bestrahlung der UV-härtbaren Zusammensetzung (P) mit UV-Strahlung umfasst.

13. Verfahren gemäß Anspruch 12, wobei die UV-härtbare (Prä)polymerzusammensetzung (P) wenigstens ein photoreaktives Monomer oder Oligomer und einen Photoinitiator umfasst.

14. Verfahren gemäß Anspruch 13, wobei die photoreaktiven Monomere oder Oligomere ausgewählt sind aus der Gruppe bestehend aus
(3-Glycidyloxypropyl)triethoxysilan,
(3-Methacryloxypropyl)trimethoxysilan,
(3-Methacryloxypropyl)dimethylmethoxysilan,
(3-Acryloxypropyl)trimethoxysilan.

15. Verfahren gemäß einem der vorstehenden Ansprüche, wobei die Zusammensetzung (P) SiO₂- und/oder ZrO₂-Partikel mit mittleren Größen in dem Bereich zwischen 1 und 15 nm umfasst.

## Revendications

1. Procédé de réplication d'un motif, ledit procédé comprenant:
(a) l'obtention d'une matrice à motif, ladite matrice à motif comprenant une surface de matrice à motif ayant une pluralité de zones en creux ou en saillie qui y sont formées;
(b) la mise en contact d'un volume d'une composition de perfluoropolyéther durcissable [composition (C)] avec ladite surface de matrice à motif, ladite composition comprenant:
- au moins un composé de perfluoropolyéther fonctionnel [composé (E)], ledit composé (E) comprenant une chaîne (per)fluoropolyoxyalkylène [chaîne (R_{f})], le poids moléculaire de ladite chaîne R_{f} étant supérieur à 1000 et inférieur à 3500 ; et au moins deux fractions insaturées; et
- au moins un photoinitiateur;
(c) la soumission à des rayonnements UV de ladite composition (C) pour produire un moule comprenant une surface de moule à motif, et la séparation dudit moule de ladite matrice à motif;
(d) la mise en contact de ladite surface de moule à motif avec une composition de (pré)polymère [composition (P)];
(e) le traitement de ladite composition (P) pour produire un article ayant une surface à motif, et la séparation dudit article dudit moule, ladite composition (P) comprenant une charge inorganique ayant une taille moyenne de particules inférieure à 1 µm.

2. Procédé selon la revendication précédente, dans lequel le composé (E) est choisi parmi ceux de formule:
T₁-J-R_{f}-J'-T₂,
dans laquelle R_{f} représente une chaîne (per)fluoropolyoxyalkylène, J et J', identiques ou différents l'un de l'autre, représentent indépendamment une liaison ou un groupe de pontage divalent, et T₁ et T₂, identiques ou différents l'un de l'autre, sont choisis dans le groupe constitué par:
(A) -O-CO-CR_{H}=CH₂,
(B) -O-CO-NH-CO-CR_{H}=CH₂,
(C) -O-CO-R^{A}-CR_{H}=CH₂,
dans lesquels R_{H} représente H ou un groupe alkyle en C₁-C₆ ; et R^{A} est choisi dans le groupe constitué par:
(j) -NH-R^{B}-O-CO-,
(jj) -NH-R^{B}-NHCOO-R^{B}-OCO-,
R^{B} étant un groupe divalent choisi dans le groupe constitué par un groupe aliphatique en C₁-C₁₀, un groupe cycloaliphatique en C₅-C₁₄, et un groupe aromatique ou alkylaromatique en C₆-C₁₄.

3. Procédé selon l'une quelconque des revendications précédentes, dans lequel ladite chaîne R_{f} répond à la formule:
-(CF₂O)ₚ(CF₂CF₂O)_{q}(CFYO)ᵣ(CF₂CFYO)ₛ-(CF₂(CF₂)_{z}CF₂O)ₜ-
dans laquelle Y est un groupe perfluoro(oxy)alkyle en C₁-C₅, z vaut 1 ou 2, et p, q, r, s et t sont des entiers ≥ 0, choisis de telle sorte que le poids moléculaire de ladite chaîne R_{f} est supérieur à 1000 et inférieur à 3500.

4. Procédé selon la revendication 3, dans lequel le composé (E) est choisi dans le groupe constitué par:
(1) les dérivés d'acrylate de formule: 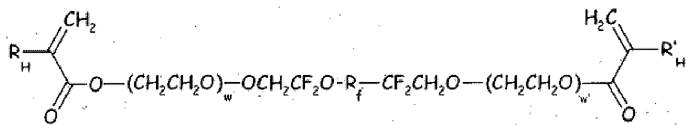 dans laquelle w et w', identiques ou différents l'un de l'autre, représentent indépendamment un entier de 0 à 5, R_{f} représentant une chaîne R_{f} telle que détaillée dans la revendication 3 et R_{H} et R'_{H} représentant H ou un groupe alkyle en C₁-C₆ ;
(2) les dérivés d'acrylamide-urée de formule: 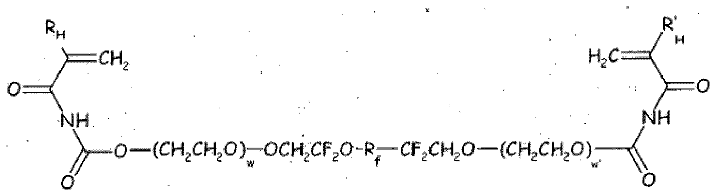 dans laquelle w et w', R_{f}, et R_{H} et R'_{H} ont la même signification que celle détaillée ci-dessus;
(3) les dérivés d'acrylate-uréthane de formule: 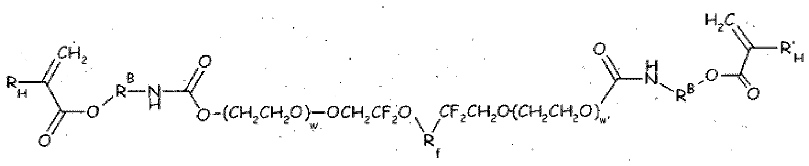 dans laquelle w et w', R_{f}, et R_{H} et R'_{H} ont la même signification que celle détaillée ci-dessus, et chacun des R^{B}, identique ou différent de l'autre, est un groupe divalent choisi dans le groupe constitué par un groupe aliphatique en C₃-C₁₀, un groupe cycloaliphatique en C₅-C₁₄, et un groupe aromatique ou alkylaromatique en C₆-C₁₄ ; et
(4) les dérivés d'uréthane-amide-acrylate de formule: 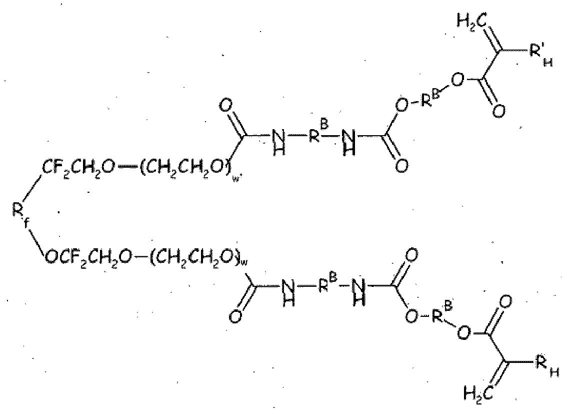 dans laquelle w et w', R_{f}, R^{B}, et R_{H} et R'_{H} ont la même signification que celle détaillée ci-dessus.

5. Procédé selon la revendication 4, dans lequel le composé (E) est choisi dans le groupe constitué par:
(i) 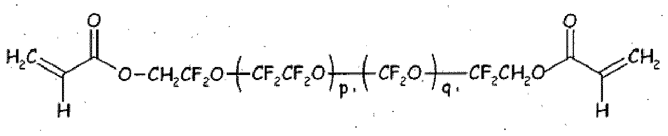
(ii) 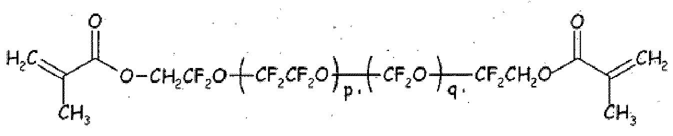
(iii) 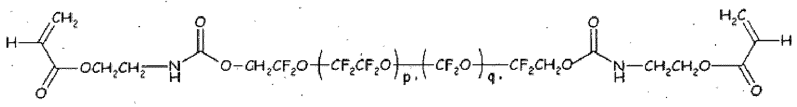
(iv) 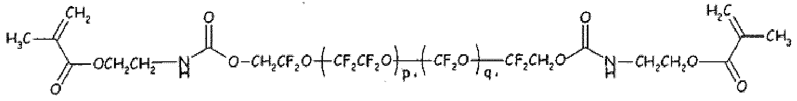
p' et q', dans les formules ci-dessus, étant choisis de telle sorte que le poids moléculaire de ladite chaîne R_{f} est supérieur à 1000 et inférieur à 3500, de préférence est compris entre 1200 et 3000, mieux encore entre 1500 et 2500.

6. Procédé selon l'une quelconque des revendications précédentes, dans lequel le photoinitiateur est choisi dans le groupe constitué par les familles suivantes:
- alpha-hydroxycétones;
- phénylglyoxylates;
- benzyldiméthylcétals;
- alpha-aminocétones;
- bisacylphosphines.

7. Procédé selon l'une quelconque des revendications précédentes, dans lequel le photoinitiateur est choisi dans le groupe constitué par:
- les alpha-hydroxycétones choisies dans le groupe constitué par:
- la 1-hydroxy-cyclohexyl-phényl-cétone;
- la 2-hydroxy-2-méthyl-1-phényl-1-propanone; et
- la 2-hydroxy-1-[4-(2-hydroxyéthoxy)phényl]-2-méthyl-1-propanone;
- les phénylglyoxylates choisis dans le groupe constitué par:
- le benzoylformate de méthyle;
- l'ester 2-[2-oxo-2-phényl-acétoxy-éthoxy]-éthylique d'acide oxy-phényl-acétique; et
- l'ester 2-[2-hydroxy-éthoxy]-éthylique d'acide oxy-phényl-acétique;
- l'alpha,alpha-diméthoxy-alpha-phénylacétophénone;
- les alpha-aminocétones choisies dans le groupe constitué par:
- la 2-benzyl-2-(diméthylamino)-1-[4-(4-morpholinyl)phényl]-1-butanone; et
- la 2-méthyl-1-[4-(méthylthio)phényl]-2-(4-morpholinyl)-1-propanone ; et
- l'oxyde de diphényl-(2,4,6-triméthylbenzoyl)-phosphine.

8. Procédé selon l'une quelconque des revendications précédentes, dans lequel la composition (C) est soumise à des rayonnements UV à l'étape (c) sous une atmosphère sensiblement dépourvue d'oxygène.

9. Procédé selon l'une quelconque des revendications précédentes, dans lequel la dose de rayonnement à l'étape (c) est d'au moins 2 J/cm², de préférence 5 J/cm².

10. Procédé selon l'une quelconque des revendications précédentes, dans lequel la composition de (pré)polymère (P) est thermoplastique ou thermodurcissable/durcissable.

11. Procédé selon la revendication 10, dans lequel la composition (P) est thermodurcissable/durcissable et dans lequel, à l'étape (d), la composition (P) est appliquée à la surface à motif du moule par des techniques de coulée puis traitée à l'étape (e) par durcissement par irradiation et/ou par chauffage.

12. Procédé selon la revendication 11, dans lequel une composition durcissable aux UV (P) est utilisée et dans lequel, à l'étape (e), le traitement comprend l'irradiation avec un rayonnement UV de ladite composition durcissable aux UV (P).

13. Procédé selon la revendication 12, dans lequel la composition de (pré)polymère durcissable aux UV (P) comprend au moins un monomère ou oligomère photoréactif et un photoinitiateur.

14. Procédé selon la revendication 13, dans lequel les monomères ou oligomères photoréactifs sont choisis dans le groupe constitué par le (3-glycidyloxypropyl)triéthoxysilane, le (3-méthacryloxypropyl)triméthoxysilane, le (3-méthacryloxypropyl)diméthylméthoxysilane, et le (3-acryloxypropyl)triméthoxysilane.

15. Procédé selon l'une quelconque des revendications précédentes, dans lequel ladite composition (P) comprend des particules de SiO₂ et/ou ZrO₂ ayant des tailles moyennes comprises entre 1 et 15 nm.
